# EUROPEAN PATENT APPLICATION

(11) **EP 1 281 980 A1**
(43) Date of publication of application: **05.02.2003**
(21) Application number: 01917594.2
(22) Date of filing: 29.03.2001
(51) Int. Cl.: G01R 33/035

(54) **MAGNETIC SENSOR**

(30) Priority: 07.04.2000 JP 2000106531
(71) Applicant: Sumitomo Electric Industries, Ltd., Osaka-shi, Osaka 541-0041 (JP)
(72) Inventor: NAGAISHI, Tatsuoki Itami Works, Itami-shi Hyogo 664-0016 (JP)
(74) Representative: HOFFMANN EITLE
(86) International application number: JP0102628
(87) International publication number: WO01077703

(57) **Abstract**

According to this invention, a magnetic sensor (1) for measuring a magnetic field distribution of an object (40) by using a SQUID (7), includes an inner container (3) forming a substantially cup-like shape to store therein a coolant (8) for cooling the SQUID, an outer container (2) which stores the inner container and has a window (23) at a position opposing a bottom of the inner container (3), and a heat conductor (6) located such that one side thereof is attached to a heat conductor attaching portion (3b) of the bottom of the inner container and the other side thereof opposes the window of the outer container, the other side being attached with the SQUID, wherein a space (4) between the inner container (3) and the outer container (2) is held in substantial vacuum, the inner container (3) is made of a metal material, and the outer container (2) is made of a nonmetallic material.

## Description

### Technical Field

The present invention relates to a magnetic sensor for measuring the magnetic field of an object with a SQUID (Superconducting QUantum Interference Device).

### Background Art

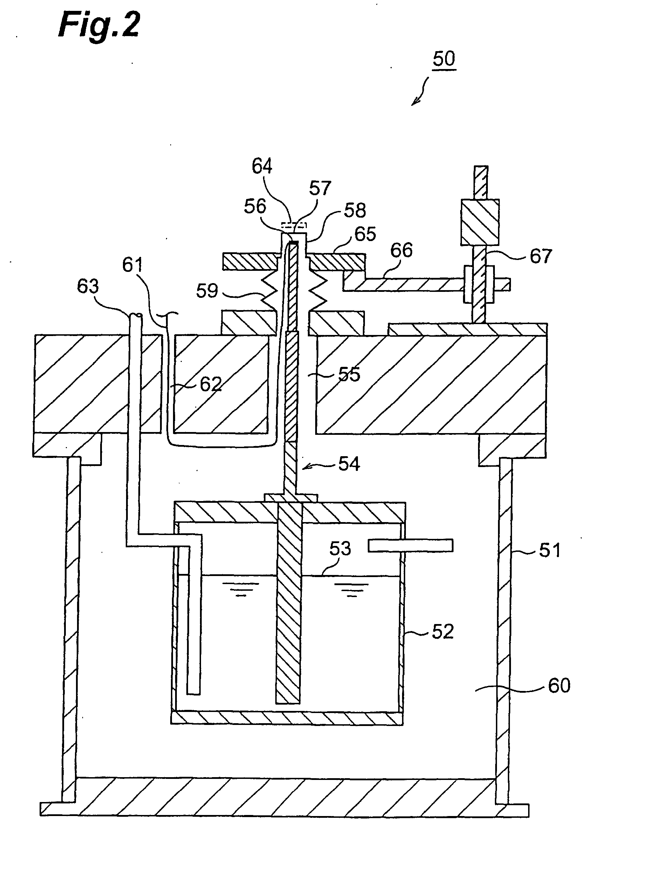

Fig. 2 is a sectional view showing a conventionally known magnetic sensor. In this magnetic sensor 50, a metal inner container 52 serving as a closed container is disposed in a metal outer container 51 which forms a housing as a closed container. The upper wall of the outer container 51 is fixed to the side wall with a plurality of bolts arranged in its circumferential direction. Liquid nitrogen 53 serving as a coolant is stored in the inner container 52, and the lower end of a cooling rod 54 serving as a heat conductor is dipped in the liquid nitrogen 53. The cooling rod 54 extends through the upper wall of the inner container 52 and projects outside the outer container 51 through a hole 55 formed in the upper wall of the outer container 51. A SQUID 56 is set on the upper end of the cooling rod 54. The cooling rod 54 is halved. The lower end side of the cooling rod 54 is formed of a copper rod with a thermal expansion coefficient substantially equal to that of the inner container 52, and the upper end side of the cooling rod 54 connected to the lower end side is formed of a sapphire rod with a comparatively small thermal expansion coefficient.

A cup-like member 58 with a window 57 is set above the cooling rod 54 to cover its upper end, and the window 57 opposes the SQUID 56. The open end of the cup-like member 58 is connected to the periphery of the hole 55 in the upper wall of the outer container 51 through a bellows 59 which allows vertical movement of the cup-like member 58. The inner space defined by the outer container 51, cup-like member 58, and bellows 59 is held substantially in vacuum to form a vacuum heat-insulating layer 60.

The SQUID 56 is connected to a signal line 61 for transmitting an information signal and the like obtained with the SQUID 56. The signal line 61 is guided downward through the hole 55 of the outer container 51 and then to the outside above the outer container 51 through an outlet hole 62 formed in the upper wall of the outer container 51. A supply pipe 63 for supplying the liquid nitrogen 53 to the inner container 52 extends through the upper wall of the outer container 51 and is connected to the inner container 52. The cup-like member 58 threadably engages with a feed screw 67, which enables vertical movement of the cup-like member 58, through a support plate 65 and support arm 66. The feed screw 67 is fixed to the upper surface of the upper wall of the outer container 51.

In the conventional magnetic sensor 50 with the above arrangement, the liquid nitrogen 53 stored in the inner container 52 cools the SQUID 56 to a superconductivity transition temperature or less through the cooling rod 54. Since the cooling rod 54 and SQUID 56 are located in the vacuum heat-insulating layer 60, heat exchange with the outside is shielded and the cooled state of the SQUID 56 is maintained. In this state, an object 64 is set above the window 57 formed in the cup-like member 58, and the SQUID 56 measures the two-dimensional magnetic field distribution of the object 64. At this time, the cup-like member 58 is vertically moved by rotating the feed screw 67, so an appropriate distance is set between the SQUID 56 and window 57, thereby improving the measurement sensitivity of the object 64.

### Disclosure of Invention

The above conventional magnetic sensor has the following problems. More specifically, since the cooling rod 54 serving as a heat conductor for conducting heat of the liquid nitrogen 53 to the SQUID 56 has one end located in the inner container 52 and the other end projecting outside the outer container 51, it is elongated and thus the cooling efficiency for the SQUID 56 is poor. When the cooling efficiency for the SQUID 56 is poor, the measurement precision of the magnetic field distribution of the object by the magnetic sensor degrades.

Of various types of components that constitute the magnetic sensor, some are made of a metal, and heat noise from the metal may decrease the measurement precision of the SQUID 56.

The present invention has been made in view of the above situation, and has as its object to provide a magnetic sensor in which a cooling efficiency for a SQUID is high and measurement precision of the magnetic field distribution of the object can be improved by decreasing heat noise.

In order to achieve the above object, according to the present invention, a magnetic sensor for measuring a magnetic field distribution of an object by using a SQUID is characterized by comprising an inner container forming a substantially cup-like shape to store therein a coolant for cooling the SQUID, an outer container which stores the inner container and has a window at a position opposing a bottom of the inner container, and a heat conductor located such that one side thereof is attached to a heat conductor attaching portion of the bottom of the inner container and the other side thereof opposes the window of the outer container, the other side being attached with the SQUID, wherein a space between the inner container and the outer container is held in substantial vacuum, the inner container is made of a metal material, and the outer container is made of a nonmetallic material.

With the magnetic sensor according to the present invention, since the heat conductor does not project outside the outer container but is accommodated in the outer container, the heat conductor can be made short. Hence, the distance through which heat of the coolant is conducted to the SQUID is shortened, so the cooling efficiency for the SQUID can be improved. Since the inner container is made of the metal material, the SQUID can be easily cooled by the coolant in the inner container through the heat conductor. Since the outer container is made of the nonmetallic material, heat noise from the metal will be prevented from entering the SQUID, so the measurement precision of the magnetic field distribution of the object can be improved.

In the magnetic sensor according to the present invention, preferably, the inner container has a male thread formed on an outer surface of an open end portion thereof and the outer container has a female thread, and the male and female threads are threadably engaged with each other to connect the inner and outer containers to each other.

When this arrangement is employed, the vacuum state between the inner and outer containers can be easily held. Also, the gap between the window of the outer container and the SQUID located on the other end side of the heat conductor attached to the inner container can be freely adjusted by changing the position of threadable engagement of the two threads.

In the magnetic sensor according to the present invention, preferably, the heat conductor attaching portion has a higher thermal conductivity than those portions of the inner container which are other than the heat conductor attaching portion.

When this arrangement is employed, heat of the coolant in the inner container can be efficiently transferred to the SQUID through the heat conductor.

Furthermore, in the magnetic sensor according to the present invention, preferably, the heat conductor attaching portion has a groove where one side of the heat conductor is to be fitted.

When this arrangement is employed, the contact area of the heat conductor and heat conductor attaching portion increases, so heat of the coolant in the inner container can be efficiently transferred to the SQUID through the heat conductor.

In the magnetic sensor according to the present invention, preferably, the outer container may comprise a substantially cylindrical portion for accommodating the inner container, and a lid member for closing the open end of the cylindrical portion and having a window.

In this case, further preferably, the cylindrical portion has a male thread formed on an outer surface of an open end portion thereof and the lid member has a female thread, and the male and female threads are threadably engaged with each other to connect the cylindrical portion and the lid member to each other. When this arrangement is employed, the gap between the SQUID located on the other end side of the heat conductor attached to the inner container and the window formed on the lid member of the outer container can be easily adjusted by changing the position of threadable engagement of the two threads.

### Brief Description of Drawings

Fig. 1 is a sectional view showing a magnetic sensor according to the first embodiment of the present invention;
Fig. 2 is a sectional view showing a conventional magnetic sensor; and
Fig. 3 is a sectional view showing a magnetic sensor according to the second embodiment of the present invention.

### Best Mode of Carrying Out the Invention

Magnetic sensors according to preferred embodiments of the present invention will be described in detail with reference to the accompanying drawings. Note that the same elements are denoted by the same reference numerals, and a repetitive description thereof will be omitted.

### [First Embodiment]

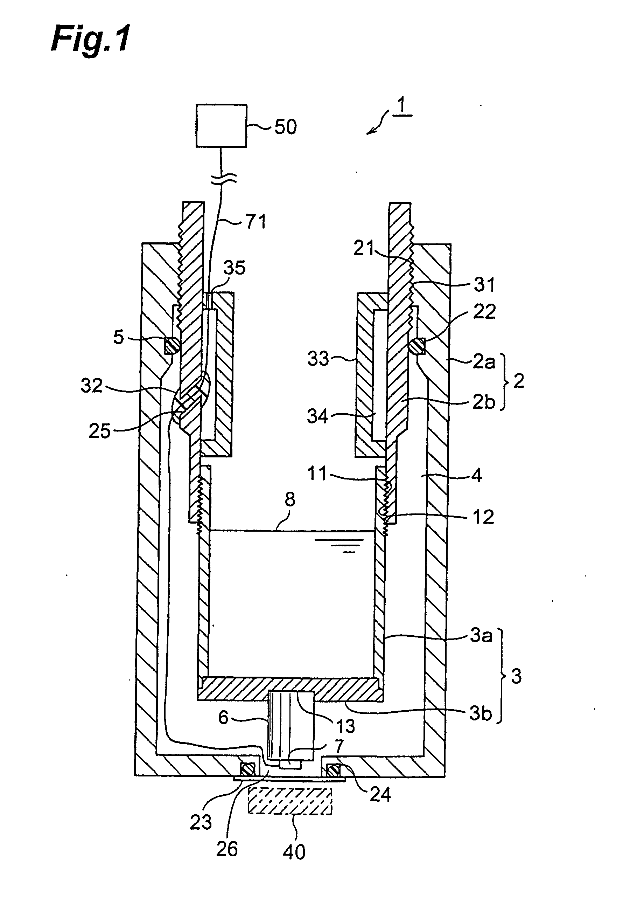

Fig. 1 is a sectional view showing a magnetic sensor 1 according to this embodiment. The magnetic sensor 1 measures the two-dimensional magnetic field distribution of an object 40 with a SQUID 7. A substantially cup-like inner container 3 is disposed in an outer container 2 made of glass fiber reinforced plastics (to be merely referred to as GFRP hereinafter) as a nonmetallic material, such that their bottoms oppose each other. Liquid nitrogen 8 as a coolant is stored in the inner container 3. GFRP has a smaller thermal conductivity than that of a metal and is nonmagnetic.

The outer container 2 is comprised of a cup-like outer container main body 2a with a female thread 21 formed at the upper portion of its inner surface, and a cylindrical connecting member 2b with a male thread 31, threadably engageable with the female thread 21, formed on the upper portion of its outer surface and a female thread 12 formed on the lower portion of its inner surface. The outer container main body 2a and connecting member 2b are both made of the GFRP described above. The connecting member 2b connects the outer container main body 2a and inner container 3 to each other.

A hole 26 is formed at the center of the bottom of the outer container main body 2a, and a sapphire plate 23 thinner than the thickness of the bottom wall of the outer container main body 2a, e.g. with a thickness of about several 100 µm, and serving as a window is bonded to the outer surface of the outer container 2 around the hole 26, thereby closing the hole 26. The sapphire plate 23 is nonmagnetic and translucent. An O-ring 24 is arranged between the sapphire plate 23 and the outer surface of the outer container 2 around the hole 26. The O-ring 24 seals the bonding portion described above.

The inner container 3 is comprised of a cylindrical member 3a with a male thread 11 formed on the outer surface of its open end, and a circular disk-like heat conductor attaching plate (heat conductor attaching portion) 3b attached to the lower end of the cylindrical member 3a by silver brazing. The lower end of the cylindrical member 3a and the outer edge of the upper surface of the heat conductor attaching plate 3b have steps that engage with each other. Both the cylindrical member 3a and heat conductor attaching plate 3b are made of metal materials. More specifically, the cylindrical member 3a is made of nonmagnetic stainless steel, and the heat conductor attaching plate 3b is made of copper which is a nonmagnetic material with a higher thermal conductivity than that of stainless steel.

The male thread 11 of the cylindrical member 3a and the female thread 12 of the connecting member 2b of the outer container 2 are threadably engaged with each other, thereby connecting the outer container 2 and inner container 3 to each other. The space which is formed by this threadable engagement between the outer container 2 and inner container 3 is held in vacuum to form a vacuum heat-insulating layer 4.

An annular groove 22 is formed in the inner surface of the outer container main body 2a at a portion which is closer to the vacuum heat-insulating layer 4 than the threadable engagement portion of the female thread 21 and male thread 31 (in the vicinity of the threadable engagement portion), and an O-ring 5 serving as a sealing member is disposed in the annular groove 22. The O-ring 5 presses against the outer surface of the connecting member 2b, thus holding the vacuum heat-insulating layer 4 in vacuum.

A cylindrical groove 13 is formed at the center of the lower surface of the heat conductor attaching plate 3b of the inner container 3, and the upper end of a sapphire rod 6 as a heat conductor is fitted in the groove 13. A silver paste is arranged between the groove 13 and sapphire rod 6 to reliably bond the heat conductor attaching plate 3b and sapphire rod 6 to each other. The lower end of the sapphire rod 6 is disposed in the vacuum heat-insulating layer 4, more specifically at that position outside the inner container 3 where it opposes the sapphire plate 23, and the SQUID 7 is attached to this lower end. The object 40 as the measurement target of the magnetic sensor 1 is set below the bottom of the outer container main body 2a of the outer container 2 so as to oppose the SQUID 7 through the sapphire plate 23.

An annular bypass member 33 is disposed on the inner surface of the connecting member 2b of the outer container 2. The lower end of the bypass member 33 is connected to that portion of the inner surface of the connecting member 2b which is below the O-ring 5, and the upper end thereof is connected to that portion of the inner surface of the connecting member 2b which is above the O-ring 5, thus defining a closed space 34 surrounded by the inner surface of the connecting member 2b and the bypass member 33. The side wall of the connecting member 2b is formed such that the thickness of its lower portion including the position where the lower end of the bypass member 33 is connected is smaller than the thickness of its upper portion.

The SQUID 7 is connected to a signal line 71 for transmitting magnetic information around the object 40 obtained with the SQUID 7. The signal line 71 extends through an outlet hole 25 formed in the side wall of the connecting member 2b to be surrounded by the bypass member 33, is guided to the outside from the vacuum heat-insulating layer 4 through an outlet hole 35 formed in the upper portion of the bypass member 33, and is connected to a signal processor 50. The outlet hole 25 is sealed with an adhesive 32 containing an epoxy resin as a main component, to hold the vacuum heat-insulating layer 4 in substantial vacuum. When the liquid nitrogen 8 is supplied into the inner container 3 from above its upper end, the magnetic sensor 1 shown in Fig. 1 is obtained.

In the magnetic sensor 1 with the above arrangement, the SQUID 7 is cooled by the liquid nitrogen 8 stored in the inner container 3 through the sapphire rod 6 to near the liquid nitrogen temperature (about 77 K), so weak magnetism induced by the object 40 can be detected. Since the lower end of the sapphire rod 6 for conducting heat of the liquid nitrogen 8 and the SQUID 7 are located in the vacuum heat-insulating layer 4, heat exchange with the outside is shielded. Thus, the SQUID 7 is held in the cooled state, and accordingly its stable operation is guaranteed.

Since the outer container 2 and inner container 3 are connected to each other through threadable engagement of the male thread 11 of the inner container 3 with the female thread 12 of the connecting member 2b, the gap between the SQUID 7 and sapphire plate 23 can be freely adjusted by changing the position of threadable engagement of the two threads 11 and 12. Thus, the gap between the SQUID 7 and sapphire plate 23 is made optimum, and the measurement sensitivity of the object 40 is improved. Since the number of components is small and a complicated position adjusting mechanism is not necessary, the manufacturing cost of the magnetic sensor 1 can be low.

Since the sapphire rod (heat conductor) 6 is not an elongated member projecting outside the outer container 2, the distance through which heat of the liquid nitrogen 8 is conducted is decreased to suppress heat dissipation, so the cooling performance of the SQUID 7 can be improved. In addition, since the sapphire rod 6 is not an elongated member, the heat conductor 6 can be made of one kind of member (sapphire). When compared to a case wherein different kinds of members are connected, the cooling performance of the SQUID 7 can be further improved.

Since the inner container 3 is made of stainless steel and copper with high thermal conductivities, the SQUID 7 can be easily cooled by the liquid nitrogen 8. In particular, since the heat conductor attaching plate 3b of the inner container 3 is made of copper with a higher thermal conductivity than that of the stainless steel cylindrical member 3a, it can transfer heat of the liquid nitrogen 8 to the SQUID 7 efficiently through the sapphire rod 6. Since the outer container 2 is made of GFRP as a nonmetallic material, heat noise from the metal is prevented from entering the SQUID 7, thereby improving the measurement precision of the magnetic field distribution of the object 40. When compared to a case wherein both the inner container 3 and outer container 2 are made of metals, since the outer container 2 is made of a nonmetallic material such as GFRP, the weight of the magnetic sensor 1 can be reduced.

Since the upper end of the sapphire rod 6 as the heat conductor is fitted in the groove 13 formed in the heat conductor attaching plate 3b, the contact area between the sapphire rod 6 and heat conductor attaching plate 3b is large, and heat of the liquid nitrogen 8 in the inner container 3 can be efficiently transferred to the SQUID 7 through the sapphire rod 6.

In addition, since the liquid nitrogen 8 is supplied from above the open end of the inner container 3, the workability of coolant supply can be improved. Since the two containers 2 and 3 are connected to each other by only threadably engaging the male thread 11 of the inner container 3 with the female thread 12 of the connecting member 2b of the outer container 2, no cumbersome operation is needed for attaching and detaching the containers 2 and 3 to and from each other. Thus, the workability during assembly and maintenance can be improved.

The signal line 71 connected to the SQUID 7 extends through the outlet hole 25 formed in the inner container 3 and is guided to the outside from the vacuum heat-insulating layer 4 through the outlet hole 35 formed in the upper portion of the bypass member 33. The signal line 71 can be guided to the outside by only passing it through two holes in the same direction. This simplifies the inserting operation of the signal line 71.

The bypass member 33 bypasses the flow of heat from the liquid nitrogen 8 conducted through the side wall of the connecting member 2b, and releases heat of the liquid nitrogen 8 from the front of the O-ring 5 in the side wall of the connecting member 2b to the vicinity of the upper end of the side wall of the connecting member 2b. Thus, hardening of the O-ring 5 by being cooled through the side wall of the connecting member 2b is prevented. Accordingly, a decrease in sealing function due to hardening of the O-ring 5 is not caused, the substantial vacuum of the vacuum heat-insulating layer 4 is further maintained, and the cooled state of the SQUID 7 can be maintained more stably.

The side wall of the connecting member 2b is formed such that its lower portion including a position where the lower end of the bypass member 33 is connected is thinner than its upper portion, and the lower end of the bypass member 33 is connected to this thin side wall portion. Therefore, heat can flow to the bypass member 33 side more easily than to the thick upper portion side of the side wall of the connecting member 2b. Cooling and hardening of the O-ring 5 can thus be further prevented, and the substantial vacuum of the vacuum heat-insulating layer 4 is further maintained, so the cooled state of the SQUID 7 can be maintained further stably.

Since the outer container 2 and inner container 3 are made of nonmagnetic materials, they will not magnetically adversely affect magnetism measurement of the object 40 with the SQUID 7, so that weak magnetism around the object 40 can be detected at high precision.

The side wall of the connecting member 2b is formed such that its lower portion including a position where the lower end of the bypass member 33 is connected is thinner than its upper portion, and the lower end of the bypass member 33 is connected to this thin side wall portion. Therefore, heat can flow to the bypass member 33 side more easily than to the thick upper portion side of the side wall of the connecting member 2b. Cooling and hardening of the O-ring 5 can thus be further prevented, and the substantial vacuum of the vacuum heat-insulating layer 4 is further maintained, so the cooled state of the SQUID 7 can be maintained further stably.

### [Second Embodiment]

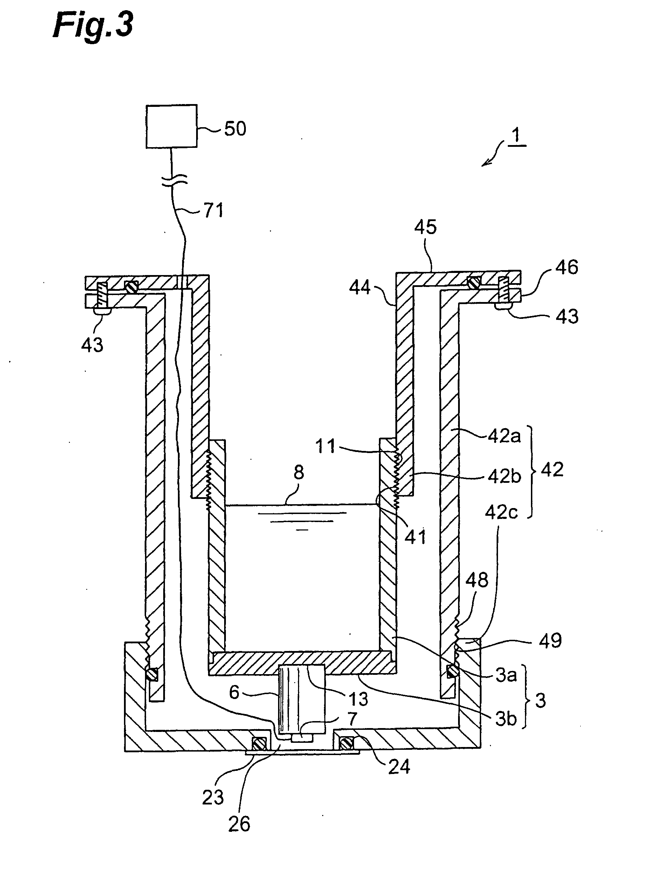

Fig. 3 is a sectional view showing a magnetic sensor according to the second embodiment of the present invention. This embodiment is different from the first embodiment in the arrangement of its outer container. As shown in Fig. 3, an outer container 42 according to this embodiment is comprised of a substantially cylindrical portion 42a for accommodating an inner container 3, a lid member 42c for closing the open end of the cylindrical portion 42a and with a sapphire plate 23 serving as a window, and a connecting member 42b for connecting the cylindrical portion 42a and inner container 3 to each other. The cylindrical portion 42a, connecting member 42b, and lid member 42c are all made of GFRP.

The connecting member 42b is comprised of a trunk 44 with a female thread 41, threadably engageable with a male thread 11 of the inner container 3, formed on its inner surface, and a flange 45 integrally formed with the trunk. The cylindrical portion 42a also has a flange 46. The flange 45 of the connecting member 42b and the flange 46 of the cylindrical portion 42a are fixed to each other with screws 43.

A male thread 48 is formed on the outer surface at the open end (a side where a SQUID 7 is located) of the cylindrical portion 42a, and a female thread 49 threadably engageable with the male thread 48 is formed on the lid member 42c. A hole 26 is formed at the center of the lid member 42c. The sapphire plate 23 is bonded to the outer surface of the periphery of the hole 26, thereby closing the hole 26.

According to the magnetic sensor of this embodiment, the gap between the SQUID 7 located at the lower end of a sapphire rod 6 attached to the inner container 3 and the sapphire plate (window) 23 formed on the lid member 42c of the outer container 42 can be freely adjusted by changing the position of threadable engagement of the male thread 48 of the cylindrical portion 42a and the female thread 49 of the lid member 42c. In particular, when compared to the first embodiment, since the lid member 42c can be rotated from the outside without putting a hand in the connecting member 42b and rotating the inner container 3, the gap between the SQUID 7 and sapphire plate 23 can be adjusted easily.

So far the present invention made by the present inventor has been described in detail regarding its embodiments. Note that the present invention is not limited to the above embodiments. For example, the connecting member need not be provided, and the male thread of the inner container may be directly threadably engaged with the female thread of the outer container main body. The materials of the inner and outer containers are not limited to those described above, but can be changed in various manners. The heat conductor may not be fitted in the groove of the heat conductor attaching portion, but may be fitted in a through hole formed in the bottom of the inner container. The heat conductor is not limited to a sapphire rod but can be one made of a nonmagnetic material with a good thermal conductivity and a small thermal expansion coefficient, e.g., ruby. The shape of the heat conductor is not limited to a rod-like shape, but can be, e.g., a plate-like shape.

As the adhesive 32 for sealing the outlet hole 25, one containing an epoxy resin as a main component is used. Alternatively, the adhesive 32 may be another one containing nonsaturated polyester-based resin as the main component, or another one containing an organic component of the same type as the material of the inner container 3. Adhesion bonding need not be performed, but welding may be performed.

The sapphire plate 23 serving as the window 23 is bonded to the outer surface of the outer container 2 by adhesion. Alternatively, the sapphire plate 23 may be bonded by vacuum suction. When adhesion bonding is to be performed, the O-ring 24 may be omitted. The window 23 need not be translucent as far as it is nonmagnetic. For example, part of the bottom wall may be ground from the inner side of the outer container 2 so this portion forms a thin window 23. In this case, the gap between the window 23 and the SQUID 7 can be set to an optimal value by adjusting the screw amount of the male thread 31 with respect to the female thread 21.

### Industrial Applicability

As has been described above, with the magnetic sensor according to the present invention, since the heat conductor does not project outside the outer container but is accommodated in the outer container, the heat conductor can be made short. Hence, the distance through which heat of the coolant is conducted to the SQUID is shortened, so the cooling efficiency for the SQUID can be improved. Since the inner container is made of a metal material, the SQUID can be easily cooled by the coolant in the inner container through the heat conductor. Since the outer container is made of a nonmetallic material, heat noise from the metal will be prevented from entering the SQUID, so the measurement precision of the magnetic field distribution of the object can be improved.

## Claims

1. A magnetic sensor for measuring a magnetic field distribution of an object by using a SQUID, **characterized by** comprising:
an inner container forming a substantially cup-like shape to store therein a coolant for cooling the SQUID;
an outer container which stores said inner container and has a window at a position opposing a bottom of said inner container; and
a heat conductor located such that one side thereof is attached to a heat conductor attaching portion of the bottom of said inner container and the other side thereof opposes the window of said outer container, the other side being attached with the SQUID, wherein
a space between said inner container and said outer container is held in substantial vacuum,
said inner container is made of a metal material, and
said outer container is made of a nonmetallic material.

2. A magnetic sensor according to claim 1, **characterized in that**
said inner container has a male thread formed on an outer surface of an open end portion thereof and said outer container has a female thread, and
said male and female threads are threadably engaged with each other to connect said inner and outer containers to each other.

3. A magnetic sensor according to claim 1, **characterized in that** the heat conductor attaching portion has a higher thermal conductivity than those portions of said inner container which are other than the heat conductor attaching portion.

4. A magnetic sensor according to claim 1, **characterized in that** the heat conductor attaching portion has a groove where one side of said heat conductor is to be fitted.

5. A magnetic sensor according to claim 1, **characterized in that** the outer container comprises a substantially cylindrical portion for accommodating said inner container, and a lid member for closing the open end of said cylindrical portion and having the window.

6. A magnetic sensor according to claim 5, **characterized in that**
said cylindrical portion has a male thread formed on an outer surface of an open end portion thereof and said lid member has a female thread, and
said male and female threads are threadably engaged with each other to connect said cylindrical portion and said lid member to each other.
